# EUROPEAN PATENT APPLICATION

(11) **EP 3 133 743 A1**
(43) Date of publication of application: **22.02.2017**
(21) Application number: 15780434.5
(22) Date of filing: 27.03.2015
(51) Int. Cl.: H04B 3/50, B60L 11/18, H02J 7/00, H03H 7/06, H03H 7/09

(54) **COMMUNICATION APPARATUS**

(30) Priority: 17.04.2014 JP 2014085519
(71) Applicant: AutoNetworks Technologies, Ltd., Yokkaichi-shi, Mie 510-8503 (JP); Sumitomo Wiring Systems, Ltd., Yokkaichi-shi Mie 510-8503 (JP); Sumitomo Electric Industries, Ltd., Osaka-shi, Osaka 541-0041 (JP)
(72) Inventor: IGARASHI, Takashi, Yokkaichi-shi Mie 510-8503 (JP); NII, Kazuhiko, Yokkaichi-shi Mie 510-8503 (JP); HAGIHARA, Takeshi, Yokkaichi-shi Mie 510-8503 (JP)
(74) Representative: Horn Kleimann Waitzhofer Patentanwälte PartG mbB
(86) International application number: PCT/JP2015/059672
(87) International publication number: WO 2015/159684

(57) **Abstract**

Provided is a communication apparatus according to which the degree of balance between two electric wires on which a signal is sent can be increased. A vehicle (4) includes a communication apparatus (44) for transmitting and receiving a superposed signal in which a charge control signal having a frequency band that includes a direct-current component and a communication signal having a frequency band that is different from the frequency band of the charge control signal are superposed, via a control line (47) and a ground line (48). In the communication apparatus (44), a common-mode noise filter (60) removes common-mode noise from the superposed signal. A LPF (50) extracts the charge control signal from the superposed signal from which the common-mode noise is removed, and outputs the extracted charge control signal to a charge control apparatus (43). The BPF (62) extracts a communication signal from the superposed signal from which the common-mode noise is removed, and outputs the extracted communication signal to a communication unit (66) via a protective circuit (64) and a conversion circuit (65).

## Description

### Technical Field

The present invention relates to a communication apparatus for superposing a plurality of signals having different frequency bands on a shared (i.e. the same) electric wire, and transmitting and receiving the superposed signal.

### Background Art

In recent years, plug-in hybrid cars and electric cars have come to be in widespread use. Thus, charging stands provided with commercially available power supply apparatuses for charging the battery of those vehicles need to be installed. In addition to the function of charging the battery, the commercially available power supply apparatuses need to be provided with a vehicle authentication function, a function of transmitting and receiving billing-related information for billing in accordance with the supplied amount of power, and so on.

The above-described power supply apparatuses include a power supply apparatus for transmitting and receiving a charge control signal such as a control pilot (CPLT) signal, a communication signal required for authentication, billing management, or the like. A communication apparatus is mounted on a vehicle. In the vehicle, the battery is charged in accordance with the charge control signal, and the communication apparatus transmits and receives the communication signal to and from the power supply apparatus. A communication apparatus for transmitting and receiving a plurality of signals having different frequency bands via two electric wires is disclosed in Patent Document 1.

### Citation List

### Patent Documents

- Patent Document 1:: JP 2012-227820A

### Summary of Invention

### Technical Problem

There is a risk that in communication with two electric wires, the waveform of a signal will be distorted due to the influence of common-mode noise that is mixed from the outside in a signal sent on the two electric wires, the noise being propagated on the two electric wires in a common mode, and an erroneous signal will be transmitted or received. Therefore, the communication apparatus of Patent Document 1 includes a common-mode noise removal unit constituted by a common mode choke coil. The common-mode noise removal unit removes common-mode noise that is propagated on the two electric wires in the common mode. However, if the impedances of the two electric wires are different from each other, a portion of common-mode noise is converted into normal noise and the converted normal mode noise passes through the common-mode noise removal unit. In such a communication apparatus, in order to efficiently remove noise, the degree of balance between the two electric wires that are connected to the common-mode noise removal unit and on which a superposed signal mixed with common-mode noise is sent needs to be kept high, and the amount of normal mode noise that is converted from the common-mode noise needs to be reduced.

The present invention has been made in view of the above-described situation, and its object is to provide a communication apparatus for being capable of increasing the degree of balance between two electric wires on which a signal is sent.

### Solution to Problem

A communication apparatus according to the present invention for transmitting and receiving a superposed signal in which a first signal and a second signal having a frequency band that is different from a frequency band of the first signal and includes a direct-current component are superposed includes a common-mode noise removal unit for removing common-mode noise from the superposed signal, and a low-pass filter for extracting the second signal from a signal from which common-mode noise is removed by the common-mode noise removal unit.

The communication apparatus according to the present invention transmits and receives the superposed signal in which the first signal and the second signal having a frequency band that is different from the frequency band of the first signal and includes a direct-current component are superposed. The common-mode noise removal unit is constituted by a common mode choke coil, for example, and removes common-mode noise from the superposed signal. The low-pass filter extracts the second signal from the signal from which the common-mode noise is removed by the common-mode noise removal unit.

In the configuration above, the first signal can also be extracted from the signal from which the common-mode noise is removed, and thus it is not necessary to provide branches on two electric wires that connects apparatuses. Therefore, the degree of balance between the two electric wires can be increased. Thus, the influence of normal mode noise that passes through the common-mode noise removal unit can be reduced.

In the communication apparatus according to the present invention, the low-pass filter includes a coil and a resistor that are connected in parallel to each other.

In the communication apparatus according to the present invention, the low-pass filter includes a coil and a resistor that are connected in parallel to each other. The coil extracts the second signal from the superposed signal by attenuating a high-frequency component of the input superposed signal. The resistor attenuates vibration noise caused by rising or falling of a signal waveform. Therefore, the second signal can be received without error.

### Advantageous Effects of Invention

According to the present invention, the degree of balance between two electric wires on which a signal is sent can be increased.

### Brief Description of Drawings

FIG. 1 is a block diagram showing a configuration of a power supply system according to an embodiment of the present invention.
FIG. 2 is a block diagram showing a configuration of a communication apparatus according to an embodiment of the present invention.

### Description of Embodiments

Hereinafter, the present invention will be described in detail based on drawings showing one embodiment.

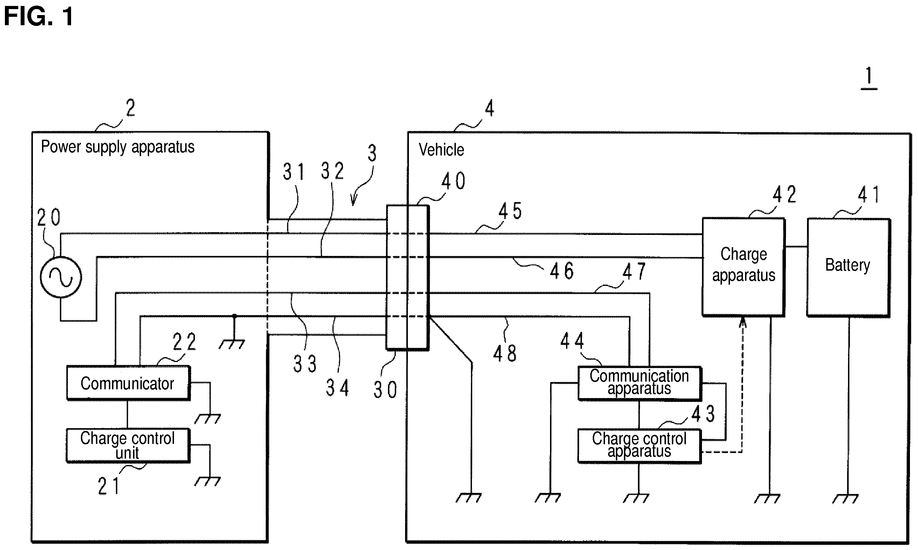

FIG. 1 is a block diagram showing a configuration of a power supply system 1 according to an embodiment of the present invention. This power supply system 1 includes a power supply apparatus 2, a charge cable 3 connected to the power supply apparatus 2, and a vehicle 4. The end of the charge cable 3 has a charge connector 30 that is detachably connected to the vehicle 4. The vehicle 4 may be a plug-in hybrid car, an electric car, or the like, and has an inlet 40 that is detachably connected to the charge connector 30 of the charge cable 3, and a battery 41.

The power supply apparatus 2 may be installed in a charging stand, for example. The power supply apparatus 2 supplies power to the battery 41 of the vehicle 4 via the charge cable 3 in a state in which the charge connector 30 of the charge cable 3 is connected to the inlet 40 of the vehicle 4.

The charge cable 3 accommodates two feeder lines 31 and 32, a control line 33 on which a charge control signal that is used to control charging of the battery 41 mounted in the vehicle 4, for example, a CPLT signal, is sent, and a ground line 34 that is a conductor for grounding. The ends of the feeder lines 31 and 32, the control line 33, and the ground line 34 on one side are connected to the charge connector 30. The feeder lines 31 and 32, the control line 33, and the ground line 34 are electric wires.

The power supply apparatus 2 includes an AC current source 20 that is connected between the other ends of the two feeder lines 31 and 32, a charge control unit 21 that transmits a charge control signal, and a communicator 22 that transmits and receives a communication signal. The communicator 22 is connected to the other ends of the control line 33 and the ground line 34, and the charge control unit 21 is connected to the control line 33 via the communicator 22. Furthermore, the ground line 34 is connected to ground potential of the power supply apparatus 2, and the charge control unit 21 and the communicator 22 are also connected to ground potential.

In addition to the inlet 40 and the battery 41, the vehicle 4 includes a charge apparatus 42 that charges the battery 41, and a charge control apparatus 43 that receives the charge control signal, and the communication apparatus 44 that transmits and receives the communication signal. The ends, on one side, of the two feeder lines 45 and 46, a control line 47 on which the charge control signal is sent, and a ground line 48 that is a lead wire for grounding are connected to the inlet 40.

The charge apparatus 42 is separately connected to the other ends of the two feeder lines 45 and 46, and to a positive terminal of the battery 41. The charge control apparatus 43 is connected to the communication apparatus 44, and is connected to the control line 47 via the communication apparatus 44. The communication apparatus 44 is connected to the other ends of the control line 47 and the ground line 48. A negative terminal of the battery 41, the charge apparatus 42, the charge control apparatus 43, the communication apparatus 44, and the ground line 48 are grounded by connecting them to the vehicle chassis. The feeder lines 45 and 46, the control line 47, and the ground line 48 are electric wires.

If the charge connector 30 of the charge cable 3 is connected to the inlet 40 of the vehicle 4, the ends of the two feeder lines 31 and 32 on one side are connected to the ends of the two feeder lines 45 and 46 on one side, one end of the control line 33 is connected to one end of the control line 47, and one end of the ground line 34 is connected to one end of the ground line 48.

If the charge connector 30 of the charge cable 3 is connected to the inlet 40 of the vehicle 4, the AC current source 20 of the power supply apparatus 2 applies an alternating voltage to the charge apparatus 42 via the feeder lines 45 and 46. The charge apparatus 42 rectifies the alternating voltage applied by the AC current source 20 to a direct voltage, and applies the rectified direct voltage to the battery 41. Accordingly, the battery 41 stores power. The battery 41 supplies the stored power to loads (not shown) in the vehicle 4, for example.

The charge control unit 21 of the power supply apparatus 2 may be a feeder circuit conforming to the international standards relating to charge control, for example. The charge control unit 21 performs charge control by confirming the connection, initiating communication, and the like by transmitting a charge control signal to the charge control apparatus 43 of the vehicle 4 and monitoring the amplitude of a charge control signal that is modified by the charge control apparatus 43. The charge control unit 21 transmits a charge control signal having a low frequency band that includes a direct-current component by applying a voltage with respect to the potential of the ground line 34 to the control line 33.

The charge control apparatus 43 of the vehicle 4 may be a vehicle circuit conforming to the international standards relating to charge control, for example. If the charge control apparatus 43 can communicate with the charge control unit 21 of the power supply apparatus 2, the charge control apparatus 43 controls the charging of the battery 41 by the charge apparatus 42, based on the charge control signal received from the charge control unit 21. Similarly to the charge control unit 21, the charge control apparatus 43 receives the charge control signal by detecting the voltage of the control line 47 with respect to the potential of the ground line 48. Also, the charge control apparatus 43 modifies the amplitude of the charge control signal by changing the impedance between the control line 47 and the ground line 48.

Also, the charge control apparatus 43 outputs charge control information relating to the control of charging the battery 41, for example, information indicating a charge amount by which the charge apparatus 42 has charged the battery 41, to the communication apparatus 44.

If the charge connector 30 of the charge cable 3 is connected to the inlet 40 of the vehicle 4, the communicator 22 of the power supply apparatus 2 transmits and receives a communication signal whose frequency band is different from that of the charge control signal to and from the communication apparatus 44 of the vehicle 4, using the control line 33 and the ground line 34 as the transmission medium, and executes in-band signaling. The frequency band of a communication signal is in a range of 2 MHz to 30 MHz, for example. The communicator 22 transmits a communication signal by applying voltage with respect to the potential of the ground line 34 to the control line 33, and receives the communication signal by detecting the voltage of the control line 33 with respect to the potential of the ground line 34.

The charge control unit 21 extracts the charge control signal by allowing the superposed signal to pass through a LPF (low pass filter) not shown in the drawings, and receives the extracted charge control signal. The communicator 22 extracts the communication signal by allowing the superposed signal to pass through a BPF (band pass filter) not shown in the drawings, that transmits a signal having a frequency band of 2 MHz to 30 MHz, for example, and receives the extracted communication signal.

The communicator 22 delivers information for vehicle authentication, charge management, billing management, or the like to the communication apparatus 44 of the vehicle 4 by transmitting and receiving the communication signal.

The communication apparatus 44 of the vehicle 4 transmits and receives the communication signal to and from the communicator 22 of the power supply apparatus 2, using the control line 47 and the ground line 48 as the transmission medium. Similarly to the communicator 22, the communication apparatus 44 transmits the communication signal by applying a voltage with respect to the potential of the ground line 48 to the control line 47, and receives the communication signal by detecting the voltage of the control line 47 with respect to the potential of the ground line 48.

As described above, the communication apparatus 44 executes in-band signaling by transmitting and receiving communication signals whose frequency band is different from that of the charge control signal, using the control line 47 and the ground line 48 as a transmission medium. A superposed signal in which the charge control signal and the communication signal are superposed is sent via the control line 33 and the ground line 34 by the charge control unit 21 transmitting the charge control signal to the charge control apparatus 43 and the communicator 22 transmitting and receiving the communication signal to and from the communication apparatus 44. Here, the communication signal corresponds to a first signal described in the claims, and the charge control signal corresponds to a second signal described in the claims.

The communication apparatus 44 delivers information for vehicle authentication, charge management, billing management, or the like to the communicator 22 of the power supply apparatus 2 by transmitting and receiving the communication signal based on the content indicated by the charge control information input from the charge control apparatus 43.

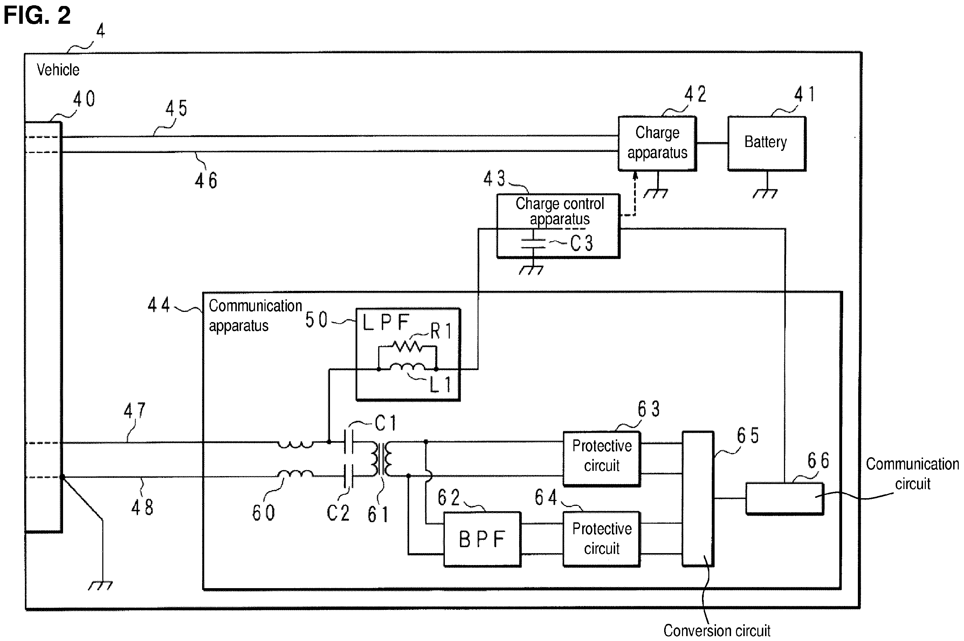

FIG. 2 is a block diagram showing a configuration of the communication apparatus 44 according to an embodiment of the present invention.

The communication apparatus 44 includes a LPF 50, a common-mode noise filter 60, an insulating transformer 61, a BPF 62, protective circuits 63 and 64, a conversion circuit 65, and a communication unit 66. The charge control apparatus 43 includes a capacitor C3.

The common-mode noise filter 60 of the communication apparatus 44 has two coils, and one end of one coil is connected to the other end of the control line 47, and one end of the other coil is connected to the other end of the ground line 48. The control line 47 and the ground line 48 that are connected between the inlet 40 and the common-mode noise filter 60 are arranged substantially in parallel or parallel to each other.

The other ends of the two coils included in the common-mode noise filter 60 are connected to one side of the capacitors C1 and C2. One coil of the insulating transformer 61 is connected between the other ends of the capacitors C1 and C2. Both ends of the other coil of the insulating transformer 61 are connected to the BPF 62 and also to the protective circuit 63. The BPF 62 is further connected to the protective circuit 64. The protective circuits 63 and 64 are connected to the conversion circuit 65, and the conversion circuit 65 is further connected to the communication unit 66. The communication unit 66 is further connected to the charge control apparatus 43.

The other end of one coil of the common-mode noise filter 60, or more specifically, a connection node between the common-mode noise filter 60 and the capacitor C1 is connected to one end of the LPF 50. Also, the other end of the LPF 50 is connected to the charge control apparatus 43, or more specifically, to one end of the capacitor C3 of the charge control apparatus 43. The other end of the capacitor C3 is grounded.

The two coils included in the common-mode noise filter 60 are so-called "common mode choke coils", and are wound in directions that are opposite to each other. If common-mode noise travels through the common-mode noise filter 60 via the control line 47 and the ground line 48, the common-mode noise is removed due to the high impedances of the coils resulting from the addition of magnetic fluxes that are generated by the common mode electric current in the coils. On the other hand, if a normal mode electric current flows through the common-mode noise filter 60, the magnetic fluxes generated in the coils are cancelled out. Therefore, the coils have low impedances with respect to normal mode electric currents. The common-mode noise filter 60 corresponds to the common-mode noise removal unit described in the claims.

Charge control information is input from the charge control apparatus 43 to the communication unit 66. The communication unit 66 delivers information for vehicle authentication, charge management, billing management, or the like to the communicator 22 of the power supply apparatus 2 by transmitting and receiving a communication signal based on the content indicated by the input charge control information.

The common-mode noise filter 60 removes common-mode noise from the superposed signal that is sent on the control line 47 and the ground line 48, and outputs a signal from which the common-mode noise is removed to the ends of the capacitors C1 and C2 on one side. The capacitors C1 and C2 remove the direct-current component of the signal from which the common-mode noise has been removed by the common-mode noise filter 60, and output a signal from which the direct-current component is removed to both ends of one coil of the insulating transformer 61. The insulating transformer 61 converts the signal that is input to both ends of the one coil into a differential signal, and outputs the converted differential signal to the BPF 62.

The BPF 62 extracts a communication signal having a predetermined frequency band, for example, a frequency band of 2 MHz to 30 MHz, from the differential signal output from the insulating transformer 61, and outputs the extracted communication signal to the conversion circuit 65 via the protective circuit 64. The protective circuit 64 is a circuit that protects the conversion circuit 65 from surge voltage, overcurrent, overvoltage, and the like.

The conversion circuit 65 converts the communication signal that has been input from the BPF 62 via the protective circuit 64 into a communication signal constituted by a bit string of "1"s and "0"s, and outputs the converted communication signal constituted by a bit string to the communication unit 66. Accordingly, the communication unit 66 receives information for vehicle authentication, charge management, billing management, or the like.

Charge control information is input to the communication unit 66 from the charge control apparatus 43. In order to deliver the information for vehicle authentication, charge management, billing management, or the like based on the input charge control information to the communicator 22 of the power supply apparatus 2, the communication unit 66 outputs the communication signal constituted by a bit string of "1"s and "0"s to the conversion circuit 65. The conversion circuit 65 converts the communication signal constituted by a bit string that has been input from the communication unit 66 into a differential signal, and outputs the communication signal that has been converted into the differential signal via the protective circuit 63 to both ends of the other coil of the insulating transformer 61. Just like the protective circuit 64, the protective circuit 63 is a circuit that protects the conversion circuit 65 from surge voltage, overcurrent, overvoltage, and the like.

The insulating transformer 61 converts the communication signal that has been converted into the differential signal by the conversion circuit 65 into a communication signal with respect to the potential of the one coil on the capacitor C2 side, and outputs the converted communication signal to the inlet 40 via the capacitors C1 and C2 and the common-mode noise filter 60. At this time, the communication signal output from the communication apparatus 44 is a communication signal that is expressed by a voltage with respect to the potential of the ground line 48. A superposed signal in which the communication signal output from the communication apparatus 44 and the charge control signal output from the charge control apparatus 43 are superposed is transmitted from the inlet 40 to the power supply apparatus 2.

The LPF 50 includes a coil L1 and a resistor R1 that are connected in parallel to each other. The coil L1 can extract a charge control signal having a low frequency component from the superposed signal by attenuating a high-frequency component of the input superposed signal. Furthermore, the coil L1 functions as a higher-order filter by forming a circuit together with the capacitor C3 of the charge control apparatus 43. Also, the resistor R1 functions as a damping resistor that attenuates vibration noise caused by rising or falling of a signal waveform. The LPF 50 outputs the extracted charge control signal to the charge control apparatus 43. The charge control apparatus 43 receives the charge control signal by detecting a voltage across both ends of the capacitor C3.

If the communication apparatus 44 is constituted as described above, the control line 47 and the ground line 48 are installed in parallel or substantially in parallel to each other. Therefore, if noise is mixed from the outside, the potentials of the control line 47 and the ground line 48 vary similarly. The transmission channel constituted by the control line 47 and the ground line 48 has a high degree of balance. Also, because it is not necessary to provide a branch on the control line 47, the impedances of the control line 47 and the ground line 48 can be made substantially equal to each other, and the degree of balance between the control line 47 and the ground line 48 can be further increased. Accordingly, noise that is mixed from the outside in the superposed signal that is sent on the control line 47 and the ground line 48 is efficiently removed by the common-mode noise filter 60.

Note that the communicator 22 of the power supply apparatus 2 may have a configuration similar to that of the communication apparatus 44 of the present invention. In this case, because it is not necessary to provide a branch on the control line 33, similarly to the control line 47 and the control line 48, the degree of balance between the control line 33 and the ground line 34 can be also increased.

The disclosed embodiments are to be considered exemplary in all respects and in no way limiting. The scope of the present invention is defined by the scope of the appended claims and not by the above description, and all changes that fall within the same essential spirit as the scope of the claims are included therein.

### Reference Signs List

- 1: Power supply system
- 2: Power supply apparatus
- 20: AC current source
- 21: Charge control unit
- 22: Communicator
- 3: Charge cable
- 30: Charge connector
- 31, 32: Feeder line
- 33: Control line
- 34: Ground line
- 4: Vehicle
- 40: Inlet
- 41: Battery
- 42: Charge apparatus
- 43: Charge control apparatus
- 44: Communication apparatus
- 45, 46: Feeder line
- 47: Control line
- 48: Ground line
- 50: LPF
- 60: Common-mode noise filter
- 61: Insulating transformer
- 62: BPF
- 63, 64: Protective circuit
- 65: Conversion circuit
- 66: Communication unit
- C1, C2, C3: Capacitor
- L1: Coil
- R1: Resistor

## Claims

1. A communication apparatus for transmitting and receiving a superposed signal in which a first signal and a second signal having a frequency band that is different from a frequency band of the first signal and includes a direct-current component are superposed, the communication apparatus comprising:
a common-mode noise removal unit for removing common-mode noise from the superposed signal; and
a low pass filter for extracting the second signal from a signal from which the common-mode noise has been removed by the common-mode noise removal unit.

2. The communication apparatus according to claim 1 wherein the low pass filter includes a coil and a resistor that are connected in parallel to each other.
